# EUROPEAN PATENT APPLICATION

(11) **EP 4 822 696 A1**
(43) Date of publication of application: **14.10.2026**
(21) Application number: 26168028.4
(22) Date of filing: 26.03.2026
(51) Int. Cl.: G11C 7/18, G11C 5/02, G11C 11/4097, H10B 12/00

(54) **SEMICONDUCTOR DEVICES INCLUDING GLOBAL BITLINES**

(30) Priority: 02.04.2025 KR 20250043055
(71) Applicant: Samsung Electronics Co., Ltd., Suwon-si, Gyeonggi-do 16677 (KR)
(72) Inventor: BAE, Taejin, 16677 Suwon-si (KR); HAN, Jinwoo, 16677 Suwon-si (KR); HAN, Seunguk, 16677 Suwon-si (KR); HAN, Sangil, 16677 Suwon-si (KR); LEE, Chanho, 16677 Suwon-si (KR); LEE, Jiyun, 16677 Suwon-si (KR); PARK, Jongwoo, 16677 Suwon-si (KR)
(74) Representative: Marks & Clerk LLP

(57) **Abstract**

A semiconductor device includes local bitlines connected to memory cells, global bitlines disposed at a level higher than a level of the local bitlines and extending in a first horizontal direction, and bitline sense amplifiers connected to the global bitlines. The global bitlines include a first global bitline and a first global complementary bitline, complementary to the first global bitline. The first global bitline includes a 1-1 bitline structure, and the first global complementary bitline includes a 2-1 bitline structure at least partially overlapping the 1-1 bitline structure in the first horizontal direction. The 1-1 bitline structure includes 1-1 lower lines spaced apart from the 1-1 lower lines in the first horizontal direction and a 1-1 upper line disposed on the 1-1 lower lines and connected to the 1-1 lower lines.

## Description

### BACKGROUND

Example embodiments of the present disclosure relate to a semiconductor device including global bitlines.

As demand for high performance, high speed, and/or multifunctionality of a semiconductor device has increased, integration of a semiconductor device has increased. In manufacturing a semiconductor device having fine patterns corresponding to the trend toward high integration of a semiconductor device, it may be necessary to implement patterns having fine widths or fine spacing distances. Also, it may be necessary to reduce the size of a semiconductor device.

### SUMMARY

An example embodiment of the present disclosure is to provide a semiconductor device in which adjacent global bitlines partially overlap each other.

According to an example embodiment of the present disclosure, a semiconductor device includes memory cells arranged in a vertical direction, a first horizontal direction and a second horizontal direction intersecting one another; local bitlines connected to the memory cells and disposed at the same level; and global bitlines disposed at a level higher than the level of the local bitlines and connected to the local bitlines, wherein the global bitlines extend in a first horizontal direction, wherein each of the memory cells includes a cell transistor including a cell gate electrode extending in the second horizontal direction, and a data storage structure, wherein the global bitlines include a first global bitline and a first global complementary bitline, complementary to the first global bitline, wherein the first global bitline includes a 1-1 bitline structure, wherein the first global complementary bitline includes a 2-1 bitline structure at least partially overlapping the 1-1 bitline structure in the first horizontal direction, and wherein the 1-1 bitline structure includes 1-1 lower lines spaced apart from each other in the first horizontal direction and a 1-1 upper line disposed on the 1-1 lower lines and connected to the 1-1 lower lines.

According to an example embodiment of the present disclosure, a semiconductor device includes memory cells arranged in a vertical direction, a first horizontal direction and a second horizontal direction intersecting one another; local bitlines connected to the memory cells and disposed at the same level; and global bitlines disposed at a level higher than the level of the local bitlines and connected to the local bitlines, wherein the global bitlines extend in a first horizontal direction, wherein each of the memory cells includes a cell transistor including a cell gate electrode extending in the second horizontal direction, and a data storage structure, wherein the global bitlines include a first global bitline and a first global complementary bitline, complementary to the first global bitline, wherein the first global bitline and the first global complementary bitline at least partially overlap each other in the first horizontal direction, wherein the first global bitline includes a 1-1 bitline structure and a 1-2 bitline structure spaced apart from each other in the first horizontal direction, wherein the first global complementary bitline includes a 2-1 bitline structure and a 2-2 bitline structure spaced apart from each other in the first horizontal direction, wherein the 2-1 bitline structure at least partially overlaps the 1-1 bitline structure in the vertical direction, and wherein the 2-2 bitline structure at least partially overlaps the 1-2 bitline structure in the vertical direction.

According to an example embodiment of the present disclosure, a semiconductor device includes memory cells arranged in a vertical direction, a first horizontal direction and a second horizontal direction intersecting one another; local bitlines connected to the memory cells and disposed at the same level; global bitlines disposed at a level higher than a level of the local bitlines and connected to the local bitlines, the global bitlines extending in a first horizontal direction; bitline sense amplifiers disposed at a level higher than the level of the global bitlines and connected to the global bitlines; and pad patterns disposed between the global bitlines and the bitline sense amplifiers in the vertical direction, connected to the global bitlines and spaced apart from each other in the first horizontal direction, wherein each of the memory cells includes a cell transistor including a cell gate electrode extending in the second horizontal direction, and a data storage structure, wherein the global bitlines include a first global bitline and a second global bitline adjacent to the first global bitline in a second horizontal direction, wherein the first global bitline includes a 1-1 bitline structure, wherein the 1-1 bitline structure includes 1-1 lower lines spaced apart from each other in the first horizontal direction and a 1-1 upper line disposed on the 1-1 lower lines and connected to the 1-1 lower lines, wherein the second global bitline includes a 3-1 lower line disposed at the same level as the 1-1 lower lines, wherein a length in the first horizontal direction of each of the 1-1 lower lines is less than a length in the first horizontal direction of the 3-1 lower line, and wherein a length by which the 3-1 lower line overlaps the 1-1 lower lines in the second horizontal direction is less than half the length of the 3-1 lower line.

According to an example embodiment of the present disclosure, a method of manufacturing a semiconductor device includes forming a first structure including memory cells, local bitlines, and global bitlines; forming a second preliminary structure including a peripheral circuit; bonding the first structure to the second preliminary structure by a wafer bonding process and forming a bonding structure; and performing an interconnection process. The global bitlines may include a first global bitline and a first global complementary bitline, complementary to the first global bitline. The first global bitline may include a 1-1 bitline structure, and the first global complementary bitline may include a 2-1 bitline structure least partially overlaps the 1-1 bitline structure in a first horizontal direction. The 1-1 bitline structure may include 1-1 lower lines spaced apart from the first horizontal direction, and a 1-1 upper line disposed on the 1-1 lower lines and connected to the 1-1 lower lines.

The memory cells may be arranged three-dimensionally in a vertical direction, a first horizontal direction, and a second horizontal direction intersecting one another, and each of the memory cells may include a cell transistor including a cell gate electrode extending in the second horizontal direction and a data storage structure.

The peripheral circuit may include bitline sense amplifiers disposed at a level higher than a level of the global bitlines and connected to the global bitlines.

The forming the first structure may include forming a lower structure including the memory cells and the local bitlines; forming the global bitlines on the lower structure; and forming a lower routing interconnection structure connected to the peripheral circuit on the global bitlines.

The performing the interconnection process may include forming an upper routing interconnection structure connected to the lower routing interconnection structure. The forming the upper routing interconnection structure may include forming through-electrodes penetrating the substrate of the second preliminary structure and in contact with the lower routing interconnection structure, and forming interconnections connecting the through-electrodes to the peripheral circuit.

In a plan view, the 1-1 upper line may overlap the 1-1 lower lines in the first horizontal direction.

The 2-1 bitline structure may include a 2-1 lower line disposed between the 1-1 lower lines and the 1-1 lower lines at the same level, and a 2-1 upper line connected to the 2-1 lower line and disposed at the same level as the 1-1 upper line.

The 2-1 bitline structure may further include a protrusion connected to the 2-1 lower line and extending in a second horizontal direction intersecting the first horizontal direction, and the protrusion may be connected to the 2-1 upper line.

The 2-1 upper line may overlap the 2-1 lower line in the second horizontal direction intersecting the first horizontal direction.

The 1-1 upper line of the 1-1 bitline structure may overlap the 2-1 lower line of the 2-1 bitline structure in the vertical direction.

At least some of the above and other features of the invention are set out in the claims.

### BRIEF DESCRIPTION OF DRAWINGS

The above and other aspects, features, and advantages of the present disclosure will be more clearly understood from the following detailed description, taken in combination with the accompanying drawings, in which:
FIG. 1 is a perspective diagram illustrating a semiconductor device according to example embodiments of the present disclosure;
FIG. 2 is a diagram illustrating a semiconductor device according to an example embodiment of the present disclosure;
FIG. 3 is a circuit diagram illustrating a semiconductor device according to an example embodiment of the present disclosure;
FIG. 4 is a diagram illustrating a global bitline and a bitline sense amplifier of a semiconductor device according to an example embodiment of the present disclosure;
FIG. 5 is a diagram illustrating a global bitline and a bitline sense amplifier of a semiconductor device according to an example embodiment of the present disclosure;
FIG. 6 is a perspective diagram illustrating a local bitline and a global bitline according to an example embodiment of the present disclosure;
FIG. 7 is an exploded perspective diagram illustrating the global bitline illustrated in FIG. 6;
FIGS. 8 to 11 are diagrams illustrating global bitlines and bitline sense amplifiers of a semiconductor device according to example embodiments of the present disclosure;
FIG. 12 is a vertical cross-sectional diagram illustrating a semiconductor device according to example embodiments of the present disclosure;
FIG. 13 is an enlarged diagram illustrating a portion of the semiconductor device illustrated in FIG. 12;
FIG. 14 is a perspective diagram illustrating memory cells and local bitlines of a semiconductor device according to an example embodiment of the present disclosure;
FIGS. 15A and 15B are flowcharts illustrating a method of manufacturing a semiconductor device according to an example embodiment of the present disclosure; and
FIGS. 16 to 19 are vertical cross-sectional diagrams illustrating processes of a method of manufacturing a semiconductor device in order according to an example embodiment of the present disclosure.

### DETAILED DESCRIPTION

Hereinafter, embodiments of the present disclosure will be described as follows with reference to the accompanying drawings.

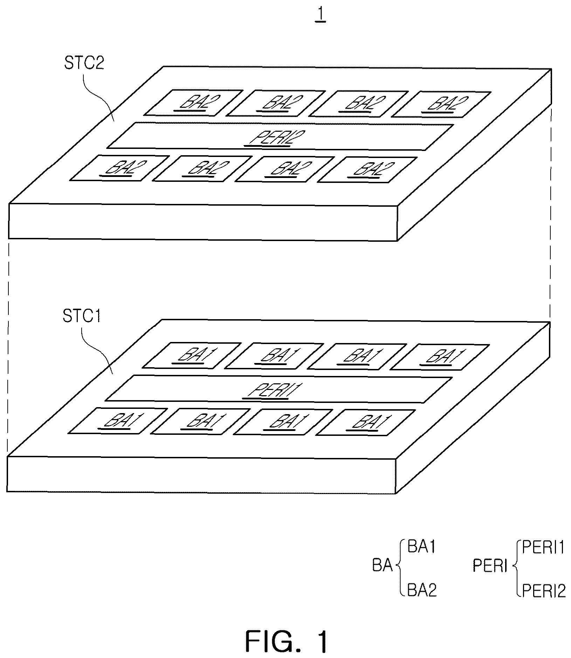

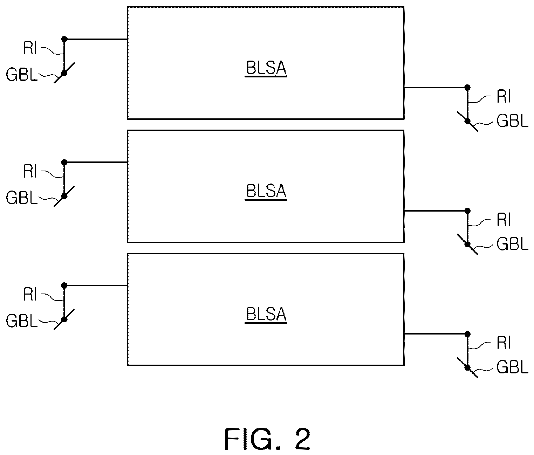

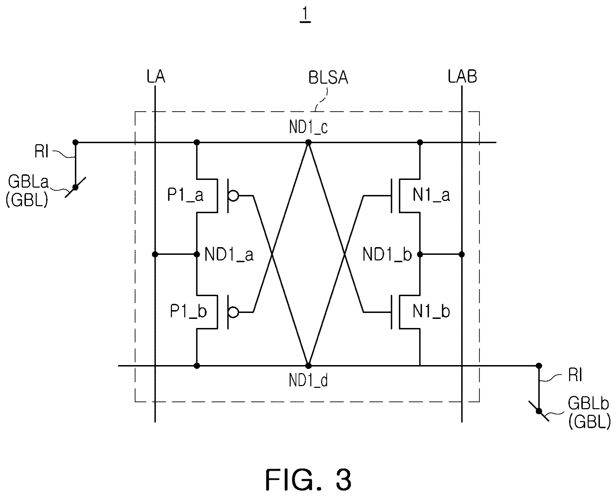

FIG. 1 is a perspective diagram illustrating a semiconductor device according to example embodiments. FIG. 2 is a diagram illustrating a semiconductor device according to an example embodiment. FIG. 3 is a circuit diagram illustrating a semiconductor device according to an example embodiment.

Referring to FIGS. 1 to 3, a semiconductor device 1 according to an example embodiment may include a first structure STC1 and a second structure STC2 on the first structure STC1. The first structure STC1 and the second structure STC2 may be bonded to each other by a wafer bonding process.

In an example, in the first structure STC1 and the second structure STC2, an insulating layer of the first structure STC1 and an insulating layer of the second structure STC2 may be bonded to each other.

In an example, the first structure STC1 and the second structure STC2 may be formed by bonding an insulating layer of the first structure STC1 and an insulating layer of the second structure STC2 to each other, and bonding a metal layer (e.g., a copper layer) of the first structure STC1 and a metal layer (e.g., a copper layer) of the second structure STC2 to each other.

The semiconductor device 1 may include a plurality of banks BA and an external peripheral region PERI. The external peripheral region PERI may include a first peripheral region PERI1 in the first structure STC1, and a second peripheral region PERI2 in the second structure STC2. The external peripheral region PERI may be a peripheral circuit region in which peripheral circuits for input/output of data or commands, or input of power/ground, are disposed.

Each of the plurality of banks BA may include a first bank region BA1 in the first structure STC1 and a second bank region BA2 in the second structure STC2.

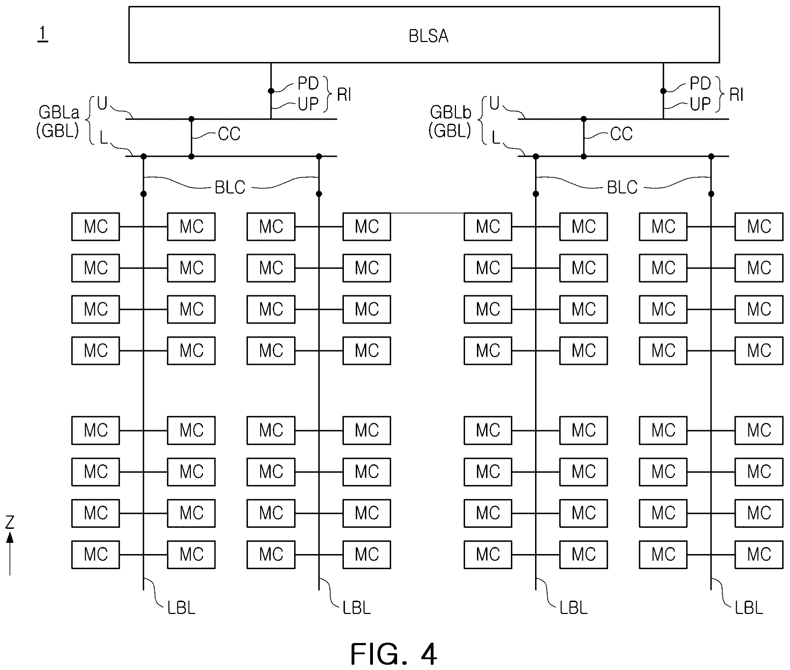

The first bank region BA1 of the first structure STC1 may include memory cells arranged three-dimensionally (e.g., MC in FIG. 4), local bitlines connected to the memory cells (e.g., LBL in FIG. 4), and global bitlines GBL connected to the local bitlines.

Each of the global bitlines GBL may be connected to an N number of local bitlines among the local bitlines (e.g., LBL in FIG. 4). "N" may be a natural number equal to or greater than 2.

The second bank region BA2 of the second structure STC2 may include bitline sense amplifiers BLSA.

The first and second structures STC1 and STC2 may further include routing interconnection structures RI configured to electrically connect the bitline sense amplifiers BLSA to the global bitlines GBL. The bitline sense amplifiers BLSA may be connected to the global bitlines GBL through the routing interconnection structures RI. The routing interconnection structures RI may be configured to electrically connect the global bitlines GBL to the bitline sense amplifiers BLSA.

Each of the bitline sense amplifiers BLSA may include a plurality of sense amplifier transistors P1_a, P1_b, N1_a, and N1_b. The sense amplifier transistors P1_a, P1_b, N1_a, and N1_b may include a first PMOS transistor P1_a, a second PMOS transistor P1_b, a first NMOS transistor N1_a and a second NMOS transistor N1_b.

The first PMOS transistor P1_a and the second PMOS transistor P1_b may be referred to as a PMOS transistor pair, and the first NMOS transistor N1_a and the second NMOS transistor N1_b may be referred to as an NMOS transistor pair.

A source of the first PMOS transistor P1_a and a source of the second PMOS transistor P1_b may be connected to the first control line LA through the first node ND1_a. A source of the first NMOS transistor N1_a and a source of the second NMOS transistor N1_b may be connected to the second control line LAB through the second node ND1_b. The first node ND1_a and the second node ND1_b may be referred to as the first source node and the second source node, respectively.

A drain of the first PMOS transistor P1_a and a drain of the first NMOS transistor N1_a may be connected to the first global bitline GBLa among the global bitlines GBL through the first drain node ND1_c. A drain of the second PMOS transistor P1_b and a drain of the second NMOS transistor N1_b may be connected to the second global bitline GBLb complementary to the first global bitline GBLa among the global bitlines GBL through the second drain node ND1_d. The bitline sense amplifier BLSA may sense a voltage change of the first global bitline GBLa and may amplify the voltage change. A reference voltage may be applied to the second global bitline GBLb complementary to the first global bitline GBLa. The bitline sense amplifier BLSA may apply an internal power voltage to the first node ND1_a through the first control line LA when sensing and amplifying operations are performed, and the second node ND1_b may be connected to a ground terminal through the second control line LAB. The bitline sense amplifier BLSA includes a PMOS transistor pair and an NMOS transistor pair, and may be implemented as a circuit configuration in which the transistors are cross-coupled to each other, but an example embodiment thereof is not limited thereto. For example, the circuit of the bitline sense amplifier BLSA may be implemented with various circuit configurations.

An example in which the global bitlines GBL described above are connected to local bitlines LBL, respectively, will be described with reference to FIG. 4.

FIG. 4 is a diagram illustrating a global bitline and a bitline sense amplifier of a semiconductor device according to an example embodiment.

In an example embodiment, referring to FIG. 4, the local bitlines LBL may be connected to memory cells MC arranged in the vertical direction Z among the memory cells MC. Each of the local bitlines LBL may be a pillar shape extending in the vertical direction Z.

The global bitlines GBL may include a first global bitline GBLa and a second global bitline GBLb complementary to the first global bitline GBLa. A bitline sense amplifier BLSA may be electrically connected to the first global bitline GBLa and the second global bitline GBLb. The first global bitline GBLa and the second global bitline GBLb may include a lower line L and an upper line U on the lower line L, respectively. For example, the lower line L of the first global bitline GBLa and the lower line L of the second global bitline GBLb may be disposed on the local bitlines LBL, and may be disposed at the same level. For example, the upper lines U1a, U1b, U2a, U2b, U3a, U3b, U4a, U4b, U5a, U5b, U6a, U6b, U7a, U7b, U8a, and U8b described below may be disposed at the same level, and the lower lines L1a, L1b, L2a, L2b, L3a, L3b, L4a, L4b, L5a, L5b, L6a, L6b, L7a, L7b, L8a, and L8b described below may be disposed at the same level.

The upper line U of the first global bitline GBLa and the upper line U of the second global bitline GBLb may be disposed on the lower lines L and may be disposed at the same level. Each of the first global bitline GBLa and the second global bitline GBLb may further include a connection contact CC connecting the lower line L to the upper line U.

In an example embodiment, the semiconductor device 1 may further include bitline contacts BLC. The bitline contacts BLC may be disposed between the local bitlines LBL and the first global bitlines GBLa and between the local bitlines LBL and the second global bitlines GBLb.

Each of the first global bitlines GBLa may be connected to the local bitlines LBL by the bitline contacts BLC. Each of the second global bitlines GBLa may be connected to the local bitlines LBL by the bitline contacts BLC. Each of the bitline contacts BLC may have a lower surface connected to the local bitlines LBL and an upper surface connected to the first global bitlines GBLa or the second global bitlines GBLb.

In an example embodiment, the semiconductor device 1 may further include routing interconnection structures RI. The routing interconnection structures RI may be disposed between the bitline sense amplifier BLSA and the first global bitline GBLa and between the bitline sense amplifier BLSA and the second global bitline GBLb. The bitline sense amplifier BLSA may be connected to the first global bitline GBLa and the second global bitline GBLb through the routing interconnection structures RI. In an example embodiment, each of the routing interconnection structures RI may include an upper plug UP and a pad pattern PD on the upper plug UP. The upper plug UP may connect the upper line U to the pad pattern PD, and the pad pattern PD may be connected to the bitline sense amplifier BLSA.

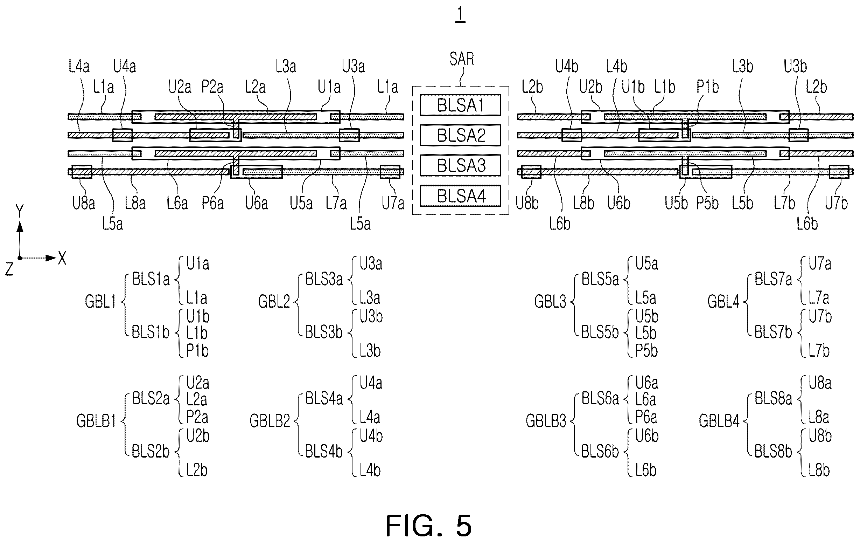

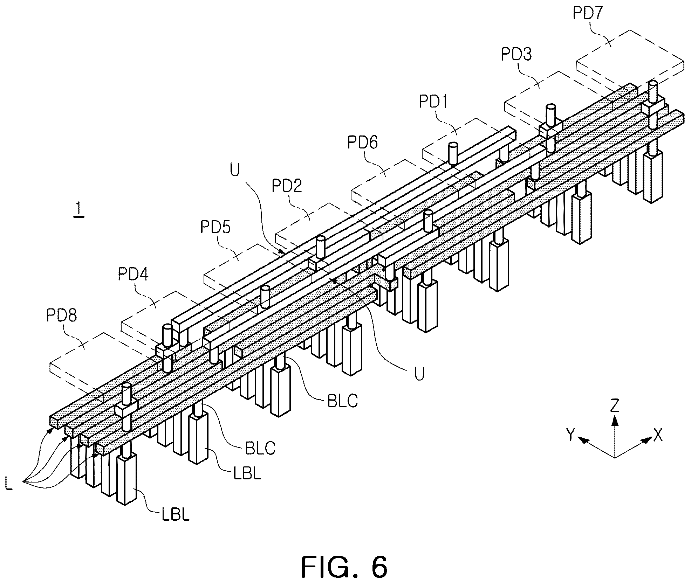

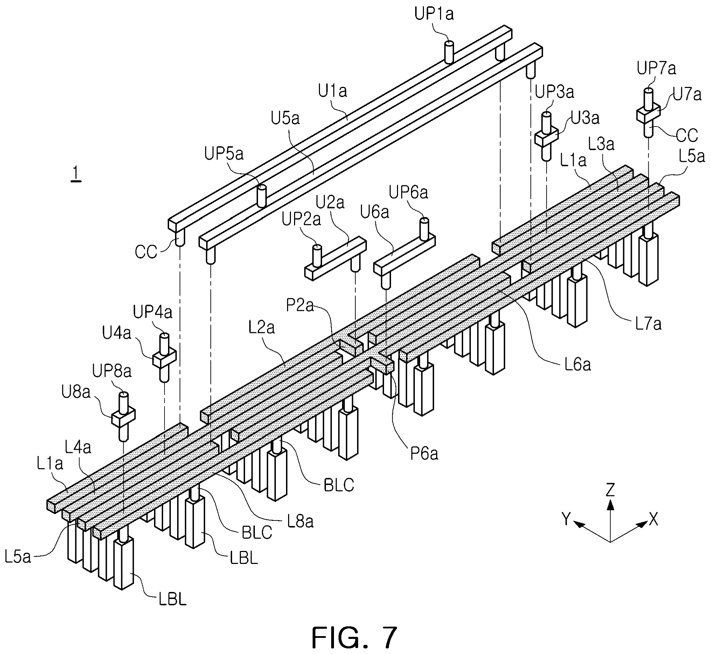

FIG. 5 is a diagram illustrating a global bitline and a bitline sense amplifier of a semiconductor device according to an example embodiment. FIG. 6 is a perspective diagram illustrating a local bitline and a global bitline according to an example embodiment. FIG. 7 is an exploded perspective diagram illustrating the global bitline illustrated in FIG. 6.

For ease of description, FIGS. 6 and 7 illustrate only the left-side structures among the structures illustrated in FIG. 5. For example, FIGS. 6 and 7 illustrate a 1-1 bitline structure BLS1a, a 2-1 bitline structure BLS2a, a 3-1 bitline structure BLS3a, a 4-1 bitline structure BLS4a, a 5-1 bitline structure BLS5a, a 6-1 bitline structure BLS6a, a 7-1 bitline structure BLS7a and a 8-1 bitline structure BLS8a, which will be described later. The 1-2 bitline structure BLS1b, the 2-2 bitline structure BLS2b, the 3-2 bitline structure BLS3b, the 4-2 bitline structure BLS4b, the 5-2 bitline structure BLS5b, the 6-2 bitline structure BLS6b, the 7-2 bitline structure BLS7b and the 8-2 bitline structure BLS8b described below may be configured the same as or similar to the 1-1 bitline structure BLS1a, the 2-1 bitline structure BLS2a, the 3-1 bitline structure BLS3a, the 4-1 bitline structure BLS4a, the 5-1 bitline structure BLS5a, the 6-1 bitline structure BLS6a, the 7-1 bitline structure BLS7a and the 8-1 bitline structure BLS8a.

Referring to FIGS. 5 to 7, a semiconductor device 1 may include global bitlines GBL (see FIG. 4) connected to a sense amplifier region SAR. The sense amplifier region SAR may include a first bitline sense amplifier BLSA1, a second bitline sense amplifier BLSA2, a third bitline sense amplifier BLSA3 and a fourth bitline sense amplifier BLSA4. The sense amplifier region SAR may be electrically connected to the global bitlines GBL. The sense amplifier region SAR may be disposed between the global bitlines GBL in FIG. 5, but an example embodiment thereof is not limited thereto. In example embodiments, a position and the size of the sense amplifier region SAR may be varied.

The global bitlines GBL may include a first global bitline GBL1, a first global complementary bitline GBLB1, a second global bitline GBL2, a second global complementary bitline GBLB2, a third global bitline GBL3, a third global complementary bitline GBLB3, a fourth global bitline GBL4 and a fourth global complementary bitline GBLB4. The first global complementary bitline GBLB1, the second global complementary bitline GBLB2, the third global complementary bitline GBLB3 and the fourth global complementary bitline GBLB4 may be complementary to the first global bitline GBL1, the second global bitline GBL2, the third global bitline GBL3 and the fourth global bitline GBL4, respectively. For example, the first global bitline GBL1 and the first global complementary bitline GBLB1 may be connected to the first bitline sense amplifier BLSA1, the second global bitline GBL2 and the second global complementary bitline GBLB2 may be connected to the second bitline sense amplifier BLSA2, the third global bitline GBL3 and the third global complementary bitline GBLB3 may be connected to the third bitline sense amplifier BLSA3, and the fourth global bitline GBL4 and the fourth global complementary bitline GBLB4 may be connected to the fourth bitline sense amplifier BLSA4.

In an example embodiment, the first global bitline GBL1, the second global bitline GBL2, the third global bitline GBL3 and the fourth global bitline GBL4 may at least partially overlap the first global complementary bitline GBLB1, the second global complementary bitline GBLB2, the third global complementary bitline GBLB3 and the fourth global complementary bitline GBLB4 in the X-direction, respectively.

The first global bitline GBL1, the second global bitline GBL2, the third global bitline GBL3 and the fourth global bitline GBL4 may be disposed in order in the Y-direction, and the first global complementary bitline GBLB1, the second global complementary bitline GBLB2, the third global complementary bitline GBLB3 and the fourth global complementary bitline GBLB4 may be disposed in order in the Y-direction.

In an example embodiment, the global bitlines GBL may extend in the X-direction. For example, the first global bitline GBL1 may include a 1-1 bitline structure BLS1a and a 1-2 bitline structure BLS1b extending at least partially in the X-direction. The 1-1 bitline structure BLS1a and the 1-2 bitline structure BLS1b may be spaced apart from each other in the X-direction and may overlap at least partially in the X-direction. The 1-1 bitline structure BLS1a may include a 1-1 upper line U1a and 1-1 lower lines L1a extending in the X-direction. The 1-1 upper line U1a may correspond to upper lines U described with reference to FIG. 4, and the 1-1 lower lines L1a may correspond to lower lines L described with reference to FIG. 4. The 1-1 lower lines L1a may be spaced apart from each other in the X-direction, and the 1-1 upper line U1a may be disposed on the 1-1 lower lines L1a. In an example embodiment, the 1-1 upper line U1a may partially overlap the 1-1 lower lines L1a in the vertical direction (Z-direction), and in a plan view, the 1-1 upper line U1a may overlap the 1-1 lower lines L1a in the X-direction. As described above, the global bitlines GBL may further include connection contacts CC. For example, the 1-1 bitline structure BLS1a may further include the connection contacts CC connecting the 1-1 upper line U1a to the 1-1 lower lines L1a and extending in the vertical direction.

The 1-2 bitline structure BLS1b may include a 1-2 upper line U1b and a 1-2 lower line L1b extending in the X-direction. The 1-2 upper line U1b and the 1-2 lower line L1b may be disposed at the same level as the 1-1 upper line U1a and 1-1 lower lines L1a, respectively.

In an example embodiment, the 1-2 bitline structure BLS1b may further include a protrusion P1b connected to the 1-2 lower line L1b and extending in the Y-direction. For example, the protrusion P1b may extend in the Y-direction from a central portion of a side surface of the 1-2 lower line L1b. The 1-2 upper line U1b may be disposed on the protrusion P1b and may partially overlap the protrusion P1b in the vertical direction. The 1-2 bitline structure BLS1b may further include a connection contact CC connecting the 1-2 upper line U1b to the protrusion P1b and extending in the vertical direction.

In an example embodiment, the 1-2 upper line U1b may not overlap the 1-2 lower line L1b in the vertical direction. For example, the 1-2 upper line U1b may be spaced apart from the 1-2 lower line L1b in the Y-direction.

As described above, the semiconductor device 1 may include routing interconnection structures RI (see FIG. 4) on the global bitlines GBL. For example, each of the routing interconnection structures RI may include upper plugs UP and pad patterns PD. In an example embodiment, the upper plugs UP may include a 1-1 upper plug UP1a, a 2-1 upper plug UP2a, a 3-1 upper plug UP3a, a 4-1 upper plug UP4a, a 5-1 upper plug UP5a, a 6-1 upper plug UP6a, a 7-1 upper plug UP7a and a 8-1 upper plug UP8a illustrated in FIG. 7. In an example embodiment, the pad patterns PD may include a first pad pattern PD1, a second pad pattern PD2, a third pad pattern PD3, a fourth pad pattern PD4, a fifth pad pattern PD5, a sixth pad pattern PD6, a seventh pad pattern PD7 and an eighth pad pattern PD8 illustrated in FIG. 6. In an example embodiment, the eighth pad pattern PD8, the fourth pad pattern PD4, the fifth pad pattern PD5, the second pad pattern PD2, the sixth pad pattern PD6, the first pad pattern PD1, the third pad pattern PD3 and the seventh pad pattern PD7 may be disposed in order in the X-direction. However, the arrangement structure of the pad patterns PD illustrated in FIG. 6 is an example and may be varied in example embodiments.

For example, a 1-1 upper plug UP1a may be disposed on the 1-1 upper line U1a of the 1-1 bitline structure BLS1a, and the 1-1 upper plug UP1a may be connected to the first pad pattern PD1. The corresponding upper plug UP and pad pattern PD may also be disposed on the 1-2 upper line U1b of the 1-2 bitline structure BLS1b. As described above, the first global bitline GBL1 may be connected to the first bitline sense amplifier BLSA1. For example, the pad pattern PD connected to the 1-2 bitline structure BLS1b and the first pad pattern PD1 connected to the 1-1 bitline structure BLS1a may be connected to the first bitline sense amplifier BLSA1.

The first global complementary bitline GBLB1 may include a 2-1 bitline structure BLS2a and a 2-2 bitline structure BLS2b extending at least partially in the X-direction. The 2-1 bitline structure BLS2a and the 2-2 bitline structure BLS2b may be spaced apart from each other in the X-direction and may at least partially overlap in the X-direction. In an example embodiment, the 2-1 bitline structure BLS2a may be configured the same as or similar to the 1-2 bitline structure BLS1b. The 2-1 bitline structure BLS2a may include a 2-1 upper line U2a and a 2-1 lower line L2a extending in the X-direction.

In an example embodiment, 2-1 bitline structure BLS2a may further include a protrusion P2a connected to the 2-1 lower line L2a and extending in the Y-direction. For example, the protrusion P2a may extend in the Y-direction from a central portion of a side surface of the 2-1 lower line L2a. The 2-1 upper line U2a may be disposed on the protrusion P2a and may partially overlap the protrusion P2a in the vertical direction. The 2-1 bitline structure BLS2a may further include a connection contact CC connecting the 2-1 upper line U2a to the protrusion P2a and extending in the vertical direction.

In an example embodiment, the 2-1 lower line L2a may overlap the 1-1 upper line U1a in the vertical direction. In an example embodiment, the 2-1 upper line U2a may not overlap the 2-1 lower line L2a in the vertical direction. For example, the 2-1 upper line U2a may be spaced apart from the 2-1 lower line L2a in the Y-direction.

In an example embodiment, the 2-2 bitline structure BLS2b may be configured the same as or similar to the 1-1 bitline structure BLS1a. The 2-2 bitline structure BLS2b may include a 2-2 upper line U2b and a 2-2 lower lines L2b extending in the X-direction. The 2-2 upper line U2b and the 2-2 lower lines L2b may be disposed at the same level as the 2-1 upper line U2a and the 2-1 lower line L2a, respectively.

The 2-2 lower lines L2b may be spaced apart from each other in the X-direction, and the 2-2 upper line U2b may be disposed on the 2-2 lower lines L2b. In an example embodiment, the 2-2 upper line U2b may partially overlap the 2-2 lower lines L2b in the vertical direction. The 2-2 bitline structure BLS2b may further include connection contacts CC connecting the 2-1 upper line U2a to the 2-2 lower lines L2b and extending in the vertical direction.

The 2-1 upper plug UP2a may be disposed on the 2-1 upper line U2a of the 2-1 bitline structure BLS2a, and the 2-1 upper plug UP2a may be connected to the second pad pattern PD2. The corresponding upper plug UP and the pad pattern PD may be disposed on the 2-2 upper line U2b of the 2-2 bitline structure BLS2b. As described above, the first global complementary bitline GBLB1 may be connected to the first bitline sense amplifier BLSA1. For example, the pad pattern PD connected to the 2-2 bitline structure BLS2b and the second pad pattern PD2 connected to the 2-1 bitline structure BLS2a may be connected to the first bitline sense amplifier BLSA1.

The second global bitline GBL2 may include a 3-1 bitline structure BLS3a and a 3-2 bitline structure BLS3b extending at least partially in the X-direction. The 3-1 bitline structure BLS3a and the 3-2 bitline structure BLS3b may be spaced apart from each other in the X-direction and may overlap at least partially in the X-direction. The 3-1 bitline structure BLS3a may include a 3-1 upper line U3a and a 3-1 lower line L3a extending in the X-direction. The 3-1 upper line U3a may be disposed on the 3-1 lower line L3a, and may partially overlap the 3-1 lower line L3a in the vertical direction. The 3-2 bitline structure BLS3b may include a 3-2 upper line U3b and a 3-2 lower line L3b extending in the X-direction. The 3-2 upper line U3b may be disposed on the 3-2 lower line L3b, and may partially overlap the 3-2 lower line L3b in the vertical direction.

A 3-1 upper plug UP3a may be disposed on the 3-1 upper line U3a of the 3-1 bitline structure BLS3a, and the 3-1 upper plug UP3a may be connected to the third pad pattern PD3. The corresponding upper plug UP and pad pattern PD may be disposed on the 3-2 upper line U3b of the 3-2 bitline structure BLS3b. As described above, the second global bitline GBL2 may be connected to the second bitline sense amplifier BLSA2. For example, the pad pattern PD connected to the 3-2 bitline structure BLS3b and the third pad pattern PD3 connected to the 3-1 bitline structure BLS3a may be connected to the second bitline sense amplifier BLSA2.

The second global complementary bitline GBLB2 may include a 4-1 bitline structure BLS4a and a 4-2 bitline structure BLS4b extending at least partially in the X-direction. The 4-1 bitline structure BLS4a and the 4-2 bitline structure BLS4b may be spaced apart from each other in the X-direction and may at least partially overlap in the X-direction.

The 4-1 bitline structure BLS4a may include a 4-1 upper line U4a and a 4-1 lower line L4a extending in the X-direction. The 4-1 upper line U4a may be disposed on the 4-1 lower line L4a and may partially overlap the 4-1 lower line L4a in the vertical direction. The 4-2 bitline structure BLS4b may include a 4-2 upper line U4b and a 4-2 lower line L4b extending in the X-direction. The 4-2 upper line U4b may be disposed on the 4-2 lower line L4b and may partially overlap the 4-2 lower line L4b in the vertical direction. In an example embodiment, the protrusion P2a of the 2-1 bitline structure BLS2a may extend between the 3-1 lower line L3a of the 3-1 bitline structure BLS3a and the 4-1 lower line L4a of the 4-1 bitline structure BLS4a. For example, the protrusion P2a may overlap the 3-1 lower line L3a and the 4-1 lower line L4a in the X-direction. The 4-1 lower line L4a may overlap the 2-1 upper line U2a in the vertical direction.

The 4-1 upper plug UP4a may be disposed on the 4-1 upper line U4a of the 4-1 bitline structure BLS4a, and the 4-1 upper plug UP4a may be connected to the fourth pad pattern PD4. The corresponding upper plug UP and pad pattern PD may be disposed on the 4-2 upper line U4b of the 4-2 bitline structure BLS4b. As described above, the second global complementary bitline GBLB2 may be connected to the second bitline sense amplifier BLSA2. For example, the pad pattern PD connected to the 4-2 bitline structure BLS4b and the fourth pad pattern PD4 connected to the 4-1 bitline structure BLS4a may be connected to the second bitline sense amplifier BLSA2.

In an example embodiment, the second global bitline GBL2 may at least partially overlap the first global bitline GBL1 and the first global complementary bitline GBLB1 in the Y-direction. For example, the 3-1 lower line L3a of the 3-1 bitline structure BLS3a may partially overlap one of the 1-1 lower lines L1a of the 1-1 bitline structure BLS1a in the Y-direction and may partially overlap the 2-1 lower line L2a of the 2-1 bitline structure BLS2a in the Y-direction. For example, a length (in the X-direction) by which the 3-1 lower line L3a overlaps each of the 1-1 lower line L1a and 2-1 lower line L2a in the Y-direction may be less than half of the length (in the X-direction) of the 3-1 lower line L3a in the X-direction.

The 3-2 lower line L3b of the 3-2 bitline structure BLS3b may partially overlap the 1-2 lower line L1b of the 1-2 bitline structure BLS1b in the Y-direction, and may partially overlap one of the 2-2 lower lines L2b of the 2-2 bitline structure BLS2b in the Y-direction. For example, the length (in the X-direction) by which the 3-2 lower line L3b overlaps the 1-2 lower line L1b and the 2-2 lower line L2b in the Y-direction may be less than half of the length (in the X-direction) of the 3-2 lower line L3b in the X-direction.

The second global complementary bitline GBLB2 may at least partially overlap the second global bitline GBL2 and the second global complementary bitline GBLB2 in the Y-direction. For example, the 4-1 lower line L4a of the 4-1 bitline structure BLS4a may partially overlap one of the 1-1 lower lines L1a of the 1-1 bitline structure BLS1a in the Y-direction, and may partially overlap the 2-1 lower line L2a of the 2-1 bitline structure BLS2a in the Y-direction. For example, the length (in the X-direction) by which the 4-1 lower line L4a overlaps the 1-1 lower line L1a and 2-1 lower line L2a in the Y-direction may be less than half of the length (in the X-direction) of the 4-1 lower line L4a in the X-direction.

The 4-2 lower line L4b of the 4-2 bitline structure BLS4b may partially overlap the 1-2 lower line L1b of the 1-2 bitline structure BLS1b in the Y-direction, and may partially overlap one of the 2-2 lower lines L2b of the 2-2 bitline structure BLS2b in the Y-direction. For example, the length (in the X-direction) by which the 4-2 lower line L4b overlaps the 1-2 lower line L1b and the 2-2 lower line L2b in the Y-direction may be less than half of the length (in the X-direction) of the 4-2 lower line L4b in the X-direction.

According to example embodiments, the global bitlines GBL adjacent to each other in the Y-direction may be disposed to partially overlap each other in the Y-direction. As illustrated in FIGS. 5 to 7, the 3-1 lower line L3a and the 3-2 lower line L3b of the second global bitline GBL2 may be disposed such that the length by which the 3-1 lower line L3a and the 3-2 lower line L3b overlap the 1-1 lower line L1a and the 1-2 lower line L1b of the first global bitline GBL1 is small, and thus, electrical coupling between the first global bitline GBL1 and the second global bitline GBL2 may be reduced. Also, the 3-1 lower line L3a and the 3-2 lower line L3b of the second global bitline GBL2 may be disposed at different levels from levels of the 1-1 upper line U1a and the 1-2 upper line U1b of the first global bitline GBL1, and thus, electrical coupling between the first global bitline GBL1 and the second global bitline GBL2 may be reduced as compared to the example in which the elements are disposed at the same level.

In an example embodiment, the third global bitline GBL3 and the third global complementary bitline GBLB3 may be configured the same as or similar to the first global bitline GBL1 and the first global complementary bitline GBLB1, respectively.

The third global bitline GBL3 may include a 5-1 bitline structure BLS5a and a 5-2 bitline structure BLS5b extending at least partially in the X-direction. The 5-1 bitline structure BLS5a and the 5-2 bitline structure BLS5b may be spaced apart from each other in the X-direction and may at least partially overlap each other in the X-direction.

The 5-1 bitline structure BLS5a may include a 5-1 upper line U5a and a 5-1 lower lines L5a extending in the X-direction. The 5-1 bitline structure BLS5a may further include connection contacts CC connecting the 5-1 upper line U5a to the 5-1 lower lines L5a and extending in the vertical direction.

The 5-2 bitline structure BLS5b may include a 5-2 upper line U5b and a 5-2 lower line L5b extending in the X-direction. In an example embodiment, the 5-2 bitline structure BLS5b may further include a protrusion P5b connected to the 5-2 lower line L5b and extending in the Y-direction. The 5-2 bitline structure BLS5b may further include a connection contact CC connecting the 5-2 upper line U5b to the protrusion P5b and extending in the vertical direction.

A 5-1 upper plug UP5a may be disposed on the 5-1 upper line U5a of the 5-1 bitline structure BLS5a, and the 5-1 upper plug UP5a may be connected to a fifth pad pattern PD5. The corresponding upper plug UP and pad pattern PD may be disposed on the 5-2 upper line U5b of the 5-2 bitline structure BLS5b. The pad pattern PD connected to the 5-2 bitline structure BLS5b and the fifth pad pattern PD5 connected to the 5-1 bitline structure BLS5a may be connected to the third bitline sense amplifier BLSA3.

The third global complementary bitline GBLB3 may include a 6-1 bitline structure BLS6a and a 6-2 bitline structure BLS6b extending at least partially in the X-direction. The 6-1 bitline structure BLS6a and the 6-2 bitline structure BLS6b may be spaced apart from each other in the X-direction and may overlap at least partially in the X-direction.

The 6-1 bitline structure BLS6a may include a 6-1 upper line U6a and a 6-1 lower line L6a extending in the X-direction. In an example embodiment, the 6-1 bitline structure BLS6a may further include a protrusion P6a connected to the 6-1 lower line L6a and extending in the Y-direction. The 6-1 bitline structure BLS6a may further include a connection contact CC connecting the 6-1 upper line U6a to the 6-1 lower line L6a and extending in the vertical direction.

The 6-2 bitline structure BLS6b may include a 6-2 upper line U6b and a 6-2 lower lines L6b extending in the X-direction. The 6-2 bitline structure BLS6b may further include connection contacts CC connecting the 6-2 upper line U6b to the 6-2 lower lines L6b and extending in the vertical direction.

The 6-1 upper plug UP6a may be disposed on the 6-1 upper line U6a of the 6-1 bitline structure BLS6a, and the 6-1 upper plug UP6a may be connected to the sixth pad pattern PD6. The corresponding upper plug UP and pad pattern PD may be disposed on the 6-2 upper line U6b of the 6-2 bitline structure BLS6b. The pad pattern PD connected to the 6-2 bitline structure BLS6b and the sixth pad pattern PD6 connected to the 6-1 bitline structure BLS6a may be connected to the third bitline sense amplifier BLSA3.

In an example embodiment, the fourth global bitline GBL4 and the fourth global complementary bitline GBLB4 may be adjacent to the third global bitline GBL3 and the third global complementary bitline GBLB3 in the Y-direction.

In an example embodiment, the fourth global bitline GBL4 and the fourth global complementary bitline GBLB4 may be configured the same as or similar to the second global bitline GBL2 and the second global complementary bitline GBLB2, respectively.

The fourth global bitline GBL4 may include a 7-1 bitline structure BLS7a and a 7-2 bitline structure BLS7b extending at least partially in the X-direction. The 7-1 bitline structure BLS7a and the 7-2 bitline structure BLS7b may be spaced apart from each other in the X-direction and may at least partially overlap in the X-direction.

The 7-1 bitline structure BLS7a may include a 7-1 upper line U7a and a 7-1 lower line L7a extending in the X-direction. The 7-1 bitline structure BLS7a may further include a connection contact CC connecting the 7-1 upper line U7a to the 7-1 lower line L7a and extending in the vertical direction.

The 7-2 bitline structure BLS7b may include a 7-2 upper line U7b and a 7-2 lower line L7b extending in the X-direction. The 7-2 bitline structure BLS7b may further include a connection contact CC connecting the 7-2 upper line U7b to the 7-2 lower line L7b and extending in the vertical direction.

A 7-1 upper plug UP7a may be disposed on the 7-1 upper line U7a of the 7-1 bitline structure BLS7a, and the 7-1 upper plug UP7a may be connected to the seventh pad pattern PD7. The corresponding upper plug UP and pad pattern PD may be disposed on the 7-2 upper line U7b of the 7-2 bitline structure BLS7b. The pad pattern PD connected to the 7-2 bitline structure BLS7b and the seventh pad pattern PD7 connected to the 7-1 bitline structure BLS7a may be connected to the fourth bitline sense amplifier BLSA4.

The fourth global complementary bitline GBLB4 may include an 8-1 bitline structure BLS8a and an 8-2 bitline structure BLS8b extending at least partially in the X-direction. The 8-1 bitline structure BLS8a and the 8-2 bitline structure BLS8b may be spaced apart from each other in the X-direction and may overlap at least partially in the X-direction.

The 8-1 bitline structure BLS8a may include an 8-1 upper line U8a and an 8-1 lower line L8a extending in the X-direction. The 8-1 bitline structure BLS8a may further include a connection contact CC connecting the 8-1 upper line U8a to the 8-1 lower line L8a and extending in the vertical direction.

The 8-2 bitline structure BLS8b may include an 8-2 upper line U8b and an 8-2 lower line L8b extending in the X-direction. The 8-2 bitline structure BLS8b may further include a connection contact CC connecting the 8-2 upper line U8b to the 8-2 lower line L8b and extending in the vertical direction.

The 8-1 upper plug UP8a may be disposed on the 8-1 upper line U8a of the 8-1 bitline structure BLS8a, and the 8-1 upper plug UP8a may be connected to the eighth pad pattern PD8. The corresponding upper plug UP and pad pattern PD may be disposed on the 8-2 upper line U8b of the 8-2 bitline structure BLS8b. The pad pattern PD connected to the 8-2 bitline structure BLS8b and the eighth pad pattern PD8 connected to the 8-1 bitline structure BLS8a may be connected to the fourth bitline sense amplifier BLSA4.

In an example embodiment, the layout structure of the 6-1 upper line U6a of the third global complementary bitline GBLB3 may be different from the 2-1 upper line U2a of the first global complementary bitline GBLB1. For example, the 6-1 upper line U6a may overlap the 7-1 lower line L7a in the vertical direction, and may not overlap the 8-1 lower line L8a in the vertical direction.

As illustrated in FIGS. 5 to 7, according to example embodiments, the 7-1 lower line L7a and the 7-2 lower line L7b of the fourth global bitline GBL4 may be disposed such that the length by which the 7-1 lower line L7a and the 7-2 lower line L7b overlap the 5-1 lower line L5a and the 5-2 lower line L5b of the third global bitline GBL3, respectively, is small, and thus, electrical coupling between the third global bitline GBL3 and the fourth global bitline GBL4 may be reduced. Also, the 7-1 lower line L7a and the 7-2 lower line L7b of the fourth global bitline GBL4 may be disposed at a level different from a level of the 5-1 upper line U5a and the 5-2 upper line U5b of the third global bitline GBL3, such that electrical coupling between the third global bitline GBL3 and the fourth global bitline GBL4 may be reduced as compared to the example in which the elements are disposed at the same level. The arrangement structure of the third global bitline GBL3 and the fourth global bitline GBL4 may be similar to that of the first global bitline GBL1 and the second global bitline GBL2, such that electrical coupling between the third global bitline GBL3 and the second global bitline GBL2 may be reduced for the reasons described above.

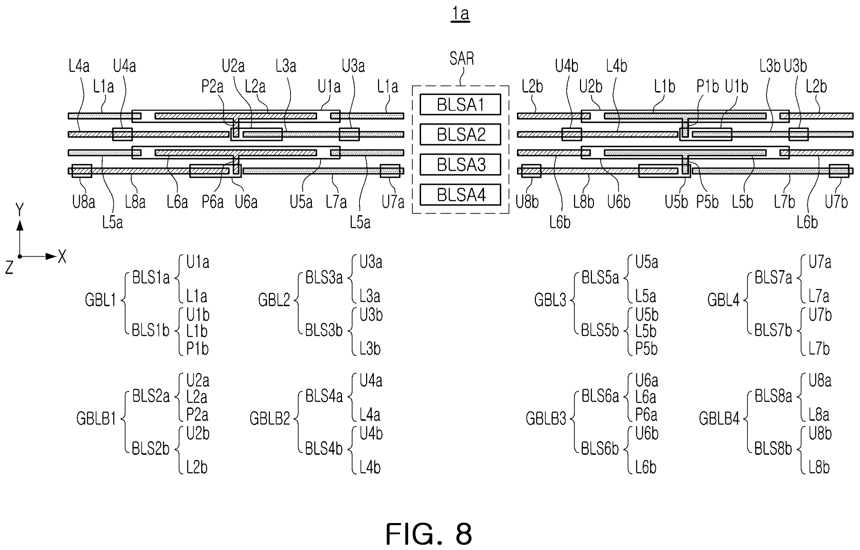

FIGS. 8 to 11 are diagrams illustrating global bitlines and bitline sense amplifiers of a semiconductor device according to example embodiments.

Referring to FIG. 8, in a semiconductor device 1a, the arrangement structure of a 1-2 upper line U1b, a 2-1 upper line U2a, a 5-2 upper line U5b and a 6-1 upper line U6a may be different from the semiconductor device 1. For example, the 1-2 upper line U1b may overlap a 3-2 lower line L3b in the vertical direction, and may not overlap a 4-2 lower line L4b in the vertical direction. The 2-1 upper line U2a may overlap a 3-1 lower line L3a in the vertical direction, and may not overlap a 4-1 lower line L4a in the vertical direction. The 5-2 upper line U5b may overlap an 8-2 lower line L8b in the vertical direction, and may not overlap a 7-2 lower line L7b in the vertical direction. The 6-1 upper line U6a may overlap an 8-1 lower line L8a in the vertical direction, and may not overlap a 7-1 lower line L7a in the vertical direction.

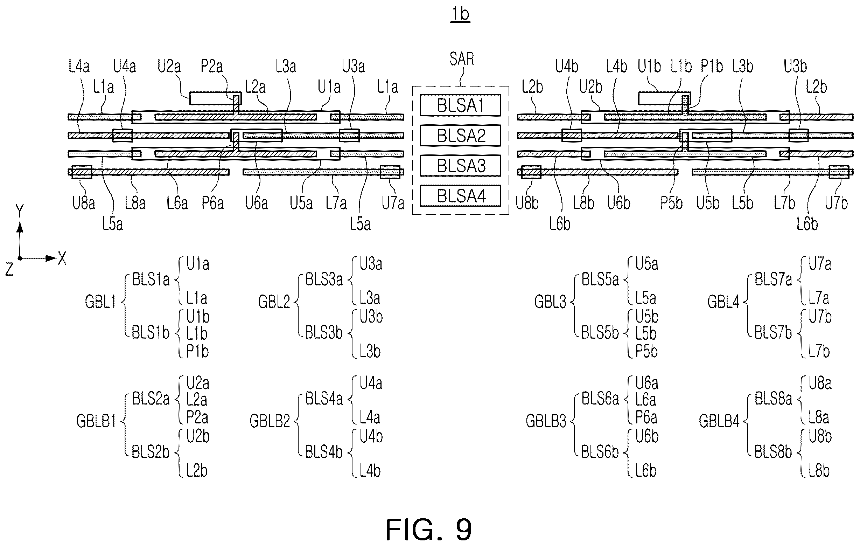

Referring to FIG. 9, in a semiconductor device 1b, the arrangement structure of protrusions P1b and P2a, P5b, and P6a may be different from the semiconductor device 1. In an example embodiment, the protrusion P1b and the protrusion P2a may not overlap a second global bitline GBL2 and a second global complementary bitline GBLB2 in the X-direction. For example, the protrusion P1b may not overlap a 3-2 lower line L3b and a 4-2 lower line L4b in the X-direction. The protrusion P2a may not overlap a 3-1 lower line L3a and a 4-1 lower line L4a in the X-direction.

In an example embodiment, a protrusion P5b and a protrusion P6a may not overlap a fourth global bitline GBL4 and a fourth global complementary bitline GBLB4 in the X-direction, and may overlap a second global bitline GBL2 and a second global complementary bitline GBLB2 in the X-direction. For example, the protrusion P5b may overlap the 3-2 lower line L3b and the 4-2 lower line L4b in the X-direction. The protrusion P2a may overlap the 3-1 lower line L3a and the 4-1 lower line L4a in the X-direction.

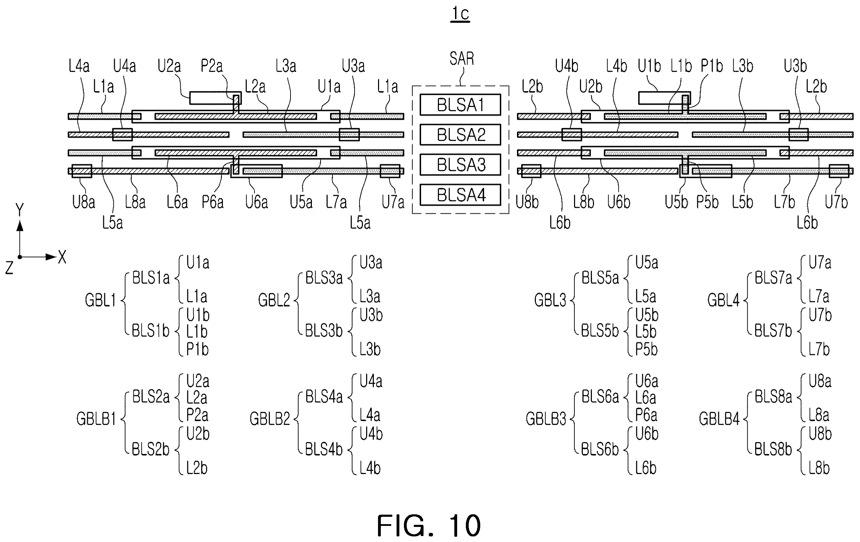

Referring to FIG. 10, in a semiconductor device 1c, the arrangement structure of the protrusions P1b and P2a may be different from the semiconductor device 1. In an example embodiment, the arrangement structure of the protrusions P1b and P2a may be the same as the arrangement structure of the protrusions P1b and P2a of the semiconductor device 1b described with reference to FIG. 9. In an example embodiment, the arrangement structure of the protrusions P5b and P6a may be the same as the arrangement structure of the protrusions P5b and P6a of the semiconductor device 1 described with reference to FIG. 7.

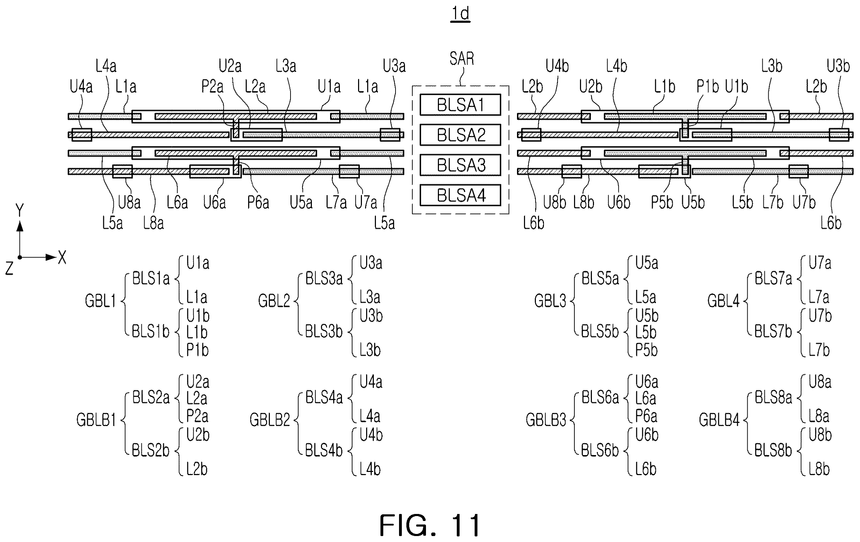

Referring to FIG. 11, in a semiconductor device 1d, the arrangement structure of the upper lines U3a, U4a, U7a, U8a, U3b, U4b, U7b, and U8b may be different from the semiconductor device 1. In an example embodiment, a 4-1 upper line U4a, an 8-1 upper line U8a, a 7-1 upper line U7a, a 3-1 upper line U3a, a 4-2 upper line U4b, an 8-2 upper line U8b, a 7-2 upper line U7b and a 3-2 upper line U3b may be arranged in order in the X-direction. Also, a fourth pad pattern PD4, an eighth pad pattern PD8, a seventh pad pattern PD7 and a third pad pattern PD3, connected to the 4-1 upper line U4a, the 8-1 upper line U8a, the 7-1 upper line U7a and the 3-1 upper line U3a, respectively, may be arranged in order in the X-direction.

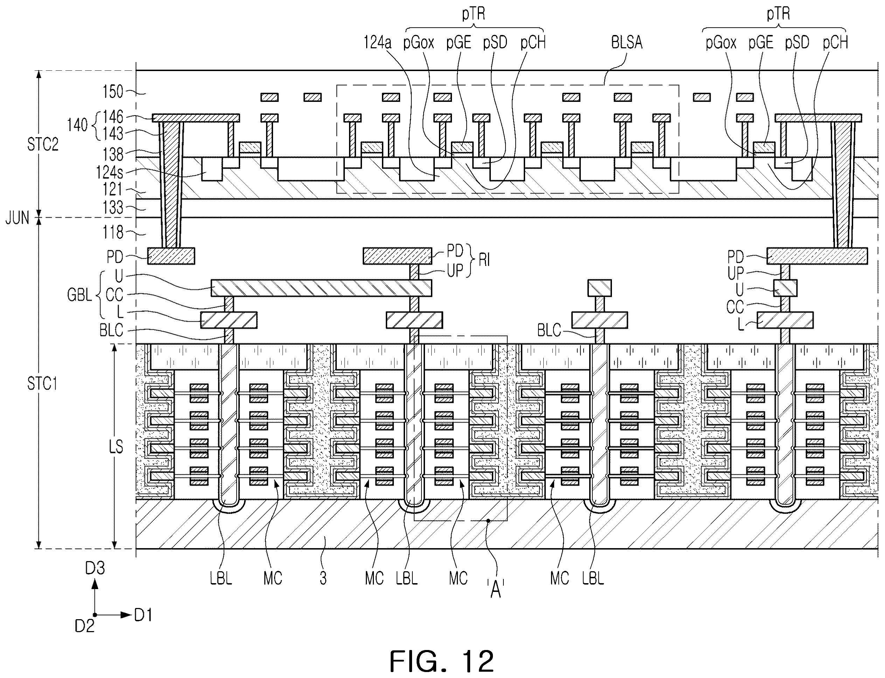

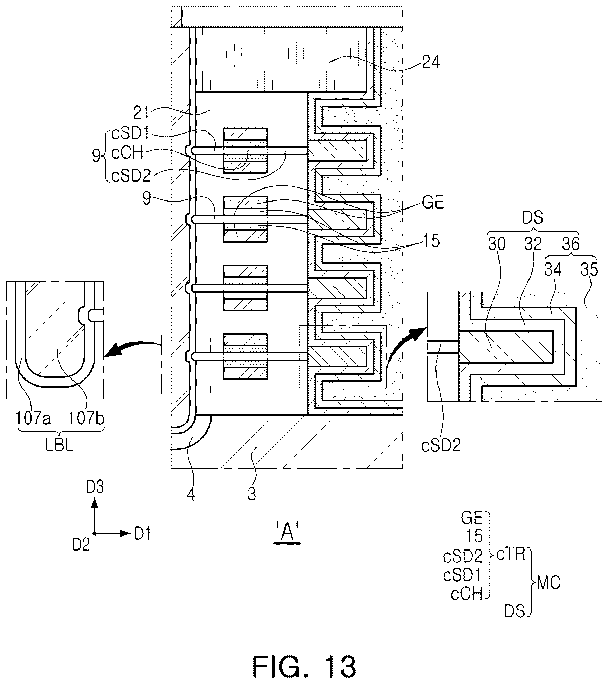

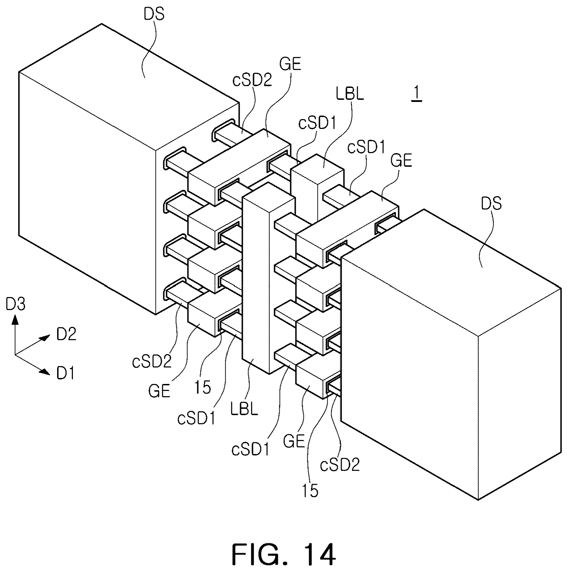

FIG. 12 is a vertical cross-sectional diagram illustrating a semiconductor device according to example embodiments. FIG. 13 is an enlarged diagram illustrating a portion of the semiconductor device illustrated in FIG. 12. FIG. 14 is a perspective diagram illustrating memory cells and local bitlines of a semiconductor device according to an example embodiment.

Referring to FIGS. 12 to 14, the first structure (STC1 in FIG. 1) of the semiconductor device 1 described above may include a lower structure LS.

The lower structure LS may include the local bitlines LBL and the memory cells MC.

The lower structure LS may include a base 3 and active patterns 9 disposed on the base 3. The base 3 may be configured as a semiconductor substrate, but an example embodiment thereof is not limited thereto. For example, the base 3 may be configured as an insulating substrate.

The active patterns 9 may be formed of a semiconductor material used as a channel region of a transistor. For example, each of the active patterns 9 may include a single crystal silicon semiconductor, an oxide semiconductor, or a two-dimensional material having semiconductor properties. Each of the active patterns 9 may may have a bar shape extending in the D1 direction. Each of the active patterns 9 may include a first source/drain region SD1 and a second source/drain region SD2, and a channel region cCH between the first and second source/drain regions SD1 and SD2, spaced apart from each other in the D1 direction.

The X-direction and the Y-direction described above may be horizontal directions parallel to an upper surface of the base 3, and the D1 direction and the D2 direction illustrated in FIG. 12 may also be horizontal directions parallel to an upper surface of the base 3. The D1 direction and the D2 direction may be the same as or different from the X-direction or the Y-direction. The Z-direction described above may be a direction perpendicular to an upper surface of the base 3, and the D3 direction illustrated in FIG. 12 may also be a direction perpendicular to an upper surface of the base 3. The Z-direction may be the same as the D3 direction.

The lower structure LS may include cell gate electrodes GE vertically overlapping the channel regions cCH, and cell gate dielectric layers 15 between the cell gate electrodes GE and the channel regions cCH. The cell gate electrodes GE may be stacked and spaced apart from each other in the D3 direction. Each of the cell gate electrodes GE may surround a corresponding channel region cCH among the channel regions cCH and may extend in the D2 direction perpendicular to the D1 direction. The cell gate electrodes GE may be configured as wordlines.

In example embodiments, each of the memory cells MC described above may include a cell transistor cTR and a data storage structure DS. The data storage structure DS may be configured as a cell capacitor which may store data in a memory such as a DRAM.

In example embodiments, each of the cell transistors cTR may include the channel region cCH, the first and second source/drain regions SD1 and SD2, the cell gate dielectric layer 15 and the cell gate electrode GE.

In example embodiments, each of the data storage structures DS may include a first electrode 30 connected to a corresponding second source/drain region SD2 of the second lower source/drain regions SD2, a second electrode 36 covering the first electrode 30, and a dielectric layer 32 between the first electrode 30 and the second electrode 36. The second electrodes 36 may be configured as plate electrodes.

In each of the data storage structures DS, the first electrode 30 may have a columnar shape extending in the D1 direction, and the second electrode 36 may include a first electrode material layer 34 in contact with the dielectric layer 32 and a second electrode material layer 35 in contact with the first electrode material layer 34. In an example embodiment, the first electrode 30 is not limited to a columnar shape. For example, the first electrode 30 may have a cylindrical shape.

In the data storage structures DS, a lower surface of each of the second electrodes 36 may be disposed at a level lower than a level of a lowermost cell transistor among the cell transistors cTR, and an upper surface of each of the second electrodes 36 may be disposed at a level higher than a level of the uppermost cell transistor among the cell transistors cTR. Each of the second electrodes 36 may extend in the D2 direction.

The memory cells MC including the cell transistors cTR and the data storage structures DS may be arranged three-dimensionally in the vertical direction D3, the D1 direction and the D2 direction, perpendicular to each other.

The lower structure LS may include a lower insulating structure 21 disposed on the base 3 and disposed on side surfaces of the second electrodes 36. The cell transistors cTR may be buried in the lower insulating structure 21.

The lower structure LS may include a capping insulating layer 24 disposed on the insulating structure 21 and disposed between the second electrodes 36. The lower structure LS may include an insulating layer 4 between the local bitlines LBL and the base 3.

Each of the local bitlines LBL may extend in the vertical direction. For example, each of the local bitlines LBL may have a columnar shape extending in the vertical direction.

On a plane, the local bitlines LBL may be arranged in the D1 direction and the D2 direction, perpendicular to each other.

Side surfaces of the local bitlines LBL may be connected to the memory cells MC. For example, the side surfaces of the local bitlines LBL may be connected to the first source/drain regions cSD1 of the cell transistors cTR of the memory cells MC. The local bitlines LBL may have recessed side surfaces in contact with the memory cells MC.

Each of the local bitlines LBL may have a columnar shape extending from a level lower than a level of the channel region cCH of the cell transistor cTR of the lowermost memory cell among the memory cells MC to a level higher than a level of the channel region cCH of the cell transistor cTR of the uppermost memory cell among the memory cells MC.

Each of the local bitlines LBL may include a pillar pattern 107b and a conductive liner 107a covering a side surface and a lower surface of the pillar pattern 107b. The conductive liner 107a may include at least one of doped polysilicon, a metal-semiconductor compound, or metal nitride. For example, the conductive liner 107a may include at least one of doped polysilicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, or CoSi, and the pillar pattern 107b may include a material different from the material of the conductive liner 107a and may include at least one of doped polysilicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, or CoSi.

The first structure STC1 may include global bitlines GBL on the lower structure LS. Each of the global bitlines GBL may extend in a horizontal direction. For example, each of the global bitlines GBL may have a line shape or a bar shape extending in the horizontal direction.

The first structure STC1 may further include bitline contacts BLC connecting the global bitlines GBL to the local bitlines LBL. The bitline contacts BLC may extend in the vertical direction and may be in contact with upper surfaces of the local bitlines LBL.

In an example embodiment, each of the global bitlines GBL may include a lower line L, an upper line U, and a connection contact CC connecting the lower line L to the upper line U

The first structure STC1 may further include pad patterns PD on the global bitlines GBL and upper plugs UP connecting the pad patterns PD to the global bitlines GBL. The upper plugs UP and the pad patterns PD may form a routing interconnection structure RI. In example embodiments, the routing interconnection structure RI may also be referred to as "lower routing interconnection structure RI."

The first structure STC1 may further include a lower insulating structure 118 disposed on the lower structure LS. The bitline contacts BLC, the global bitlines GBL, the upper plugs UP and the pad patterns PD may be buried in the lower insulating structure 118.

The second structure STC2 may include a backside insulating layer 133, a substrate 121 on the backside insulating layer 133, a peripheral circuit disposed on the substrate 121, and an upper insulating structure 150 covering the peripheral circuit on the substrate 121. The substrate 121 may be configured as a semiconductor substrate or a semiconductor body.

The lower insulating structure 118 of the first structure STC1 and the backside insulating layer 133 of the second structure STC2 may be bonded to each other, such that a bonding region JUN may be formed between the first structure STC1 and the second structure STC2.

The second structure STC2 may include a plurality of peripheral active regions 124a which may be defined by device isolation regions 124s on the substrate 121.

The peripheral circuit may include the bitline sense amplifiers BLSA described with reference to FIGS. 2 and 3.

Each of the sense amplifier transistors P1_a, P1_b, N1_a, and N1_b included in the bitline sense amplifiers BLSA described with reference to FIG. 3 may include peripheral source/drain regions pSD disposed in the peripheral active region 124a and a peripheral channel region pCH between the peripheral source/drain regions pSD, a peripheral gate electrode pGE on the peripheral channel region pCH, and a peripheral gate dielectric layer pGox between the peripheral gate electrode pGE and the peripheral channel region pCH. The peripheral source/drain regions pSD of the first NMOS transistor N1_a and the second NMOS transistor N1_b described with reference to FIG. 3 may have N-type conductivity, and the peripheral source/drain regions pSD of the first PMOS transistor P1_a and the second PMOS transistor P1_b may have P-type conductivity.

The second structure STC2 may include upper routing interconnection structures 140. The upper routing interconnection structures 140 may be connected to the lower routing interconnection structure RI.

Each of the upper routing interconnection structures 140 may include a through-electrode 143 penetrating the substrate 121 and an interconnection 146 connected to the through-electrode 143 on the substrate 121. The through-electrode 143 may be spaced apart from the substrate 121 by an insulating spacer 138 on a side surface of the through-electrode 143. The through-electrodes 143 of the upper routing interconnection structures 140 may be in contact with an upper surface of a corresponding pad pattern PD.

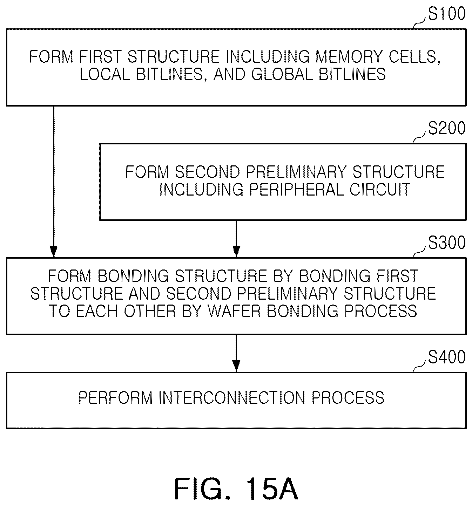

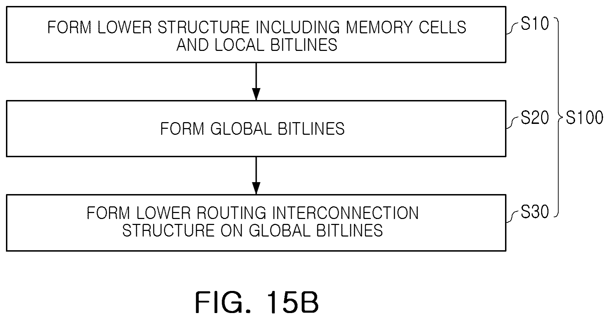

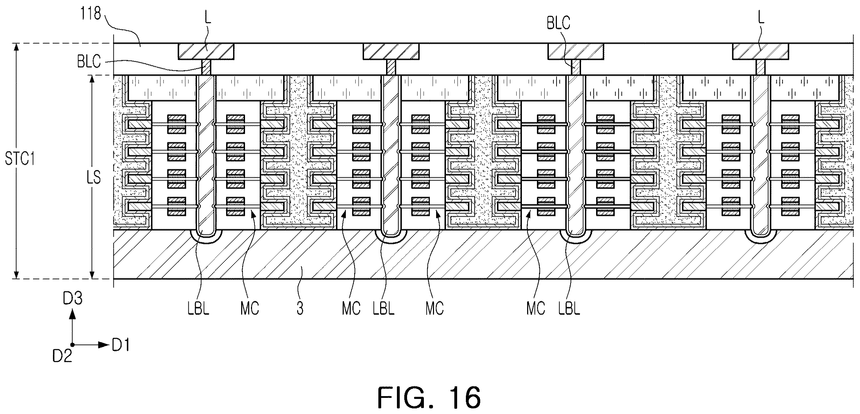

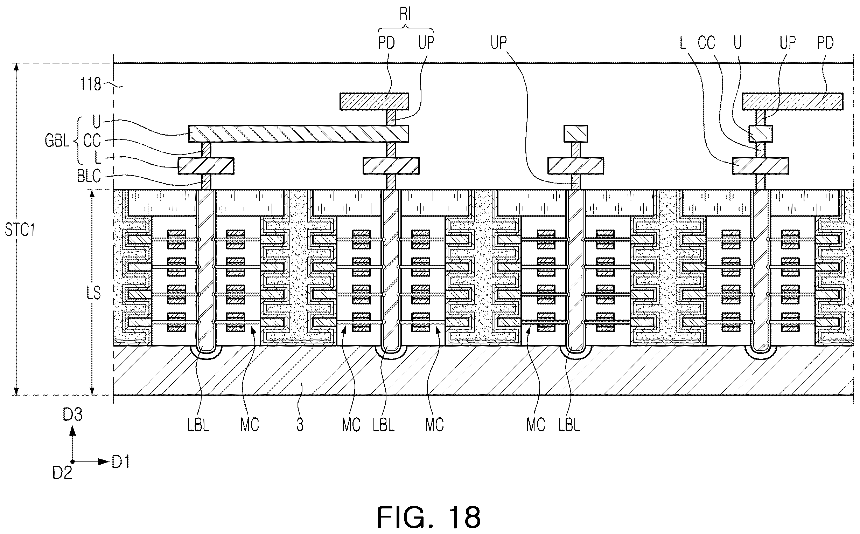

FIGS. 15A and 15B are flowcharts illustrating a method of manufacturing a semiconductor device according to an example embodiment. FIGS. 16 to 19 are vertical cross-sectional diagrams illustrating processes of a method of manufacturing a semiconductor device in order according to an example embodiment.

Referring to FIGS. 15A to 18, a first structure STC1 including memory cells MC, local bitlines LBL, and global bitlines GBL may be formed (S100). The forming the first structure STC1 (S100) may include forming a lower structure LS including the memory cells MC and the local bitlines LBL (S10), forming global bitlines GBL on the lower structure LS (S20), and forming lower routing interconnection structures RI (S30).

The lower structure LS may be substantially the same as described with reference to FIGS. 12 to 14. For example, the memory cells MC may be connected to the local bitlines LBL, and each of the memory cells MC may include the cell transistor cTR and the data storage structure DS as described with reference to FIG. 13.

The global bitlines GBL may be formed in the lower insulating structure 118 formed on the lower structure LS. For example, the global bitlines GBL may be formed by forming lower lines L extending in the horizontal direction, forming connection contacts CC extending in the vertical direction on the lower lines L, and forming upper lines U extending in the horizontal direction and connected to the connection contacts CC.

The lower routing interconnection structure RI may be formed in the lower insulating structure 118 formed on the lower structure LS. For example, the lower routing interconnection structure RI may be formed by forming upper plugs UP extending in the vertical direction and connected to the global bitlines GBL, and pad patterns PD extending in the horizontal direction and connected to the upper plugs UP.

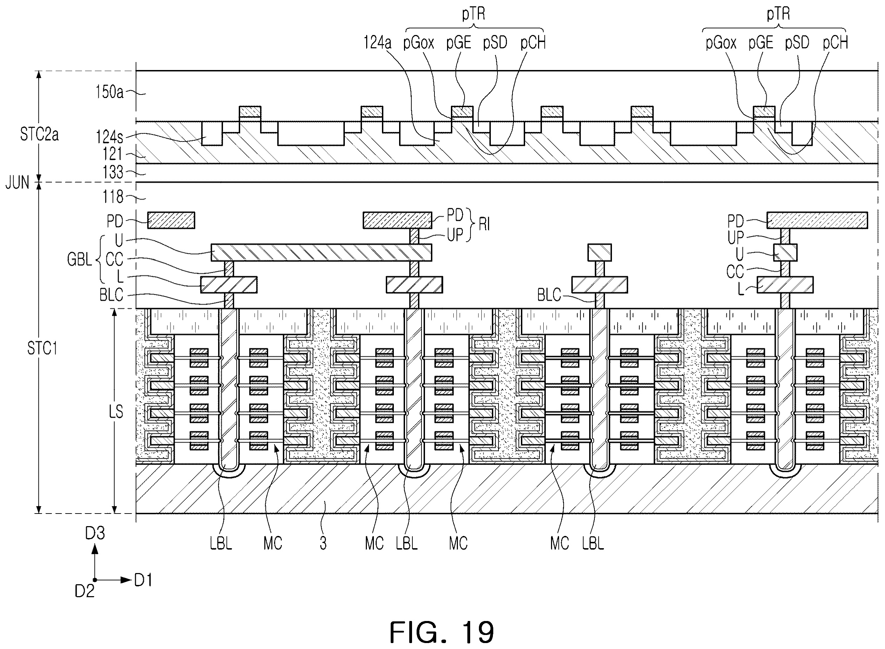

Referring to FIGS. 15A and 19, a second preliminary structure STC2a including a peripheral circuit may be formed (S200). The second preliminary structure STC2a may include a peripheral circuit including peripheral transistors pTR formed on a substrate 121, an insulating layer 150a covering the peripheral transistors pTR on the substrate 121, and a backside insulating layer 133 in a lower portion of the substrate 121. The peripheral transistors pTR may include transistors for forming the bitline sense amplifiers BLSA described with reference to FIG. 12.

The first structure STC1 and the second preliminary structure STC2a may be bonded to each other by a wafer bonding process, thereby forming bonding structures STC1 and STC2a (S300). The lower insulating structure 118 of the first structure STC1 and the backside insulating layer 133 of the second preliminary structure STC2a may be bonded to each other, thereby forming a bonding region JUN.

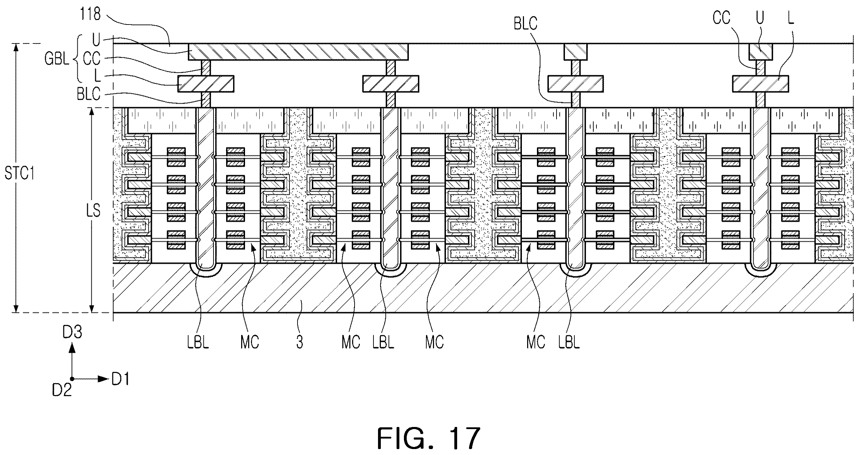

An interconnection process may be performed (S400). The performing the interconnection process may include forming the upper routing interconnection structures 140 connected to the lower routing interconnection structure RI as described with reference to FIG. 17. For example, forming through-electrodes 143 penetrating the substrate 121 of the second preliminary structure STC2a and in contact with the lower routing interconnection structure RI, and forming interconnections 146 connecting the through-electrodes 143 to the peripheral circuit may be included. Accordingly, the second structure STC2 as described with reference to FIG. 12 may be formed. Accordingly, the semiconductor device 1 including the first and second structures STC1 and STC2 bonded to each other, described with reference to FIG. 12, may be manufactured.

According to the aforementioned example embodiments, as adjacent global bitlines are disposed to partially overlap each other, electrical coupling between adjacent global bitlines may be reduced.

While the example embodiments have been illustrated and described above, it will be configured as apparent to those skilled in the art that modifications and variations could be made without departing from the scope of the present disclosure as defined by the appended claims.

## Claims

1. A semiconductor device, comprising:
memory cells (MC) arranged in a vertical direction, a first horizontal direction and a second horizontal direction intersecting one another;
local bitlines (LBL) connected to the memory cells (MC) and disposed at the same level; and
global bitlines (GBL) disposed at a level higher than the level of the local bitlines (LBL) and connected to the local bitlines (LBL),
wherein the global bitlines (GBL) extend in the first horizontal direction,
wherein each of the memory cells (MC) includes a cell transistor (cTR) including a cell gate electrode (GE) extending in the second horizontal direction, and a data storage structure (DS),
wherein the global bitlines (GBL) include a first global bitline (GBL1) and a first global complementary bitline (GBLB1), complementary to the first global bitline (GBL1),
wherein the first global bitline (GBL1) includes a 1-1 bitline structure (BLS1a),
wherein the first global complementary bitline (GBLB1) includes a 2-1 bitline structure (BLS2a) at least partially overlapping the 1-1 bitline structure (BLS1a) in the first horizontal direction, and
wherein the 1-1 bitline structure (BLS1a) includes 1-1 lower lines (L1a) spaced apart from each other in the first horizontal direction and a 1-1 upper line (U1a) disposed on the 1-1 lower lines (L1a) and connected to the 1-1 lower lines (L1a).

2. The semiconductor device of claim 1, wherein, in a plan view, the 1-1 upper line (U1a) overlaps the 1-1 lower lines (L1a) in the first horizontal direction.

3. The semiconductor device of claim 1 or 2, wherein the 2-1 bitline structure (BLS2a) includes a 2-1 lower line (L2a) disposed between the 1-1 lower lines (L1a) at the same level as the 1-1 lower lines (L1a), and a 2-1 upper line (U2a) connected to the 2-1 lower line (L2a) and disposed at the same level as the 1-1 upper line (U1a).

4. The semiconductor device of claim 3,
wherein the 2-1 bitline structure (BLS2a) further includes a protrusion (P2a) connected to the 2-1 lower line (L2a) and extending in a second horizontal direction, and
wherein the protrusion (P2a) is connected to the 2-1 upper line (U2a).

5. The semiconductor device of claim 4,
wherein the global bitlines (GBL) further include a second global bitline (GBL2) adjacent to the first global bitline (GBL1) and the first global complementary bitline (GBLB1) in a second horizontal direction, and
wherein the protrusion (P2a) at least partially overlaps the second global bitline (GBL2) in the first horizontal direction.

6. The semiconductor device of claim 4,
wherein the global bitlines (GBL) further include a second global bitline (GBL2) adjacent to the first global bitline (GBL1) and the first global complementary bitline (GBLB1) in a second horizontal direction, and
wherein the protrusion (P2a) does not at least partially overlap the second global bitline (GBL2) in the first horizontal direction.

7. The semiconductor device of claim 3, or any one of claims 4 to 6 when dependent on claim 3, wherein, in a plan view, the 2-1 upper line (U2a) overlaps the 2-1 lower line (L2a) in a second horizontal direction.

8. The semiconductor device of claim 3, wherein the 1-1 upper line (U1a) of the 1-1 bitline structure (BLS1a) overlaps the 2-1 lower line (L2a) of the 2-1 bitline structure (BLS2a) in the vertical direction.

9. The semiconductor device of claim 8, or any one of claims 4 to 8 when dependent on claim 3, wherein a length in the first horizontal direction of the 1-1 upper line (U1a) of the 1-1 bitline structure (BLS1a) is different from a length in the first horizontal direction of the 2-1 lower line (L2a) of the 2-1 bitline structure (BLS2a).

10. The semiconductor device of claim 8,
wherein the global bitlines (GBL) further include a second global bitline (GBL2) adjacent to the first global bitline (GBL1) and the first global complementary bitline (GBLB1) in a second horizontal direction,
wherein the second global bitline (GBL2) includes a 3-1 lower line (L3a) disposed at the same level as the 1-1 lower lines (L1a), and
wherein a length by which the 3-1 lower line (L3a) overlaps the 1-1 lower lines (L1a) in the second horizontal direction is less than half the length of the 3-1 lower line (L3a).

11. The semiconductor device of claim 10, wherein the second global bitline (GBL2) further includes a 3-1 upper line (U3a) on the 3-1 lower line (L3a).

12. The semiconductor device of claim 10 or 11, further comprising:
bitline sense amplifiers disposed at a level higher than the level of the global bitline, connected to the global bitlines (GBL), and including a first bitline sense amplifier (BLSA1) and a second bitline sense amplifier (BLSA2),
wherein the first global bitline (GBL1) and the first global complementary bitline (GBLB1) are connected to the first bitline sense amplifier (BLSA1), and
wherein the second global bitline (GBL2) is connected to the second bitline sense amplifier (BLSA2).

13. The semiconductor device of any preceding claim, wherein the first global bitline (GBL1) further includes a 1-2 bitline structure (BLS1b) spaced apart from the 1-1 bitline structure (BLS1a) in the first horizontal direction,
wherein the first global complementary bitline (GBLB1) further includes a 2-2 bitline structure (BLS2b) spaced apart from the 2-1 bitline structure (BLS2a) in the first horizontal direction,
wherein the 2-1 bitline structure (BLS2a) at least partially overlaps the 1-1 bitline structure (BLS1a) in the vertical direction, and
wherein the 2-2 bitline structure (BLS2b) at least partially overlaps the 1-2 bitline structure (BLS1b) in the vertical direction.

14. The semiconductor device of claim 13, wherein the 1-2 bitline structure (BLS1b) includes a 1-2 lower line (L1b), a protrusion (P1b) connected to the 1-2 lower line (L1b) and extending in the second horizontal direction, and a 1-2 upper line (U1b) connected to the protrusion (P1b).

15. The semiconductor device of claim 14, wherein the 1-2 lower line (L1b) at least partially overlaps the 1-1 lower lines (L1a) in the first horizontal direction.
